# EUROPÄISCHE PATENTSCHRIFT

(11) **EP 0 576 395 B1**
(45) Veröffentlichungstag und Bekanntmachung des Hinweises auf die Patenterteilung: **27.03.1996**
(21) Anmeldenummer: 93810418.9
(22) Anmeldetag: 10.06.1993
(51) Int. Cl.: H02H 9/04, H02H 3/02

(54) **Schutzanordnung zum Schutz elektrischer Einrichtungen gegen Ueberspannungen auf dem Stromversorgungsnetz**
Protection device for protecting an electrical appliance against overvoltage in the power distribution network
Dispositif de protection pour la protection d'in dispositif électrique contre la surtension sur le réseau électrique

(30) Priorität: 23.06.1992 DE 4220259
(43) Veröffentlichungstag der Anmeldung: 29.12.1993
(73) Patentinhaber: METEOLABOR AG, CH-8620 Wetzikon (CH)
(72) Erfinder: Bosshard, Walter, CH-8712 Stäfa (CH); Kälin, Albert, CH-8620 Wetzikon (CH)
(74) Vertreter: Rottmann, Maximilian R.

(56) Entgegenhaltungen:
- EP-A- 0 350 477
- DE-A- 4 127 457

## Beschreibung

Die Erfindung betrifft eine Schutzanordnung zum Schutz von mit Wechselstrom betriebenen elektrischen Einrichtungen gegen Überspannungen auf dem Stromversorgungsnetz, mit spannungsabhängigen Ableitelementen zur Spannungsbegrenzung, wobei an jede Leitung des Stromversorgungsnetzes ein Ableitelement angeschlossen ist und die von den Ableitelementen zur Erde führenden Strompfade parallelgeschaltet und durch den Kern eines Stromwandlers hindurchgeführt sind, dessen Sekundärwicklung mit einem Auswertegerät verbunden ist. Beim Stromversorgungsnetz kann es sich um ein ein- oder mehrphasiges Wechselstromnetz handeln.

Spannungsabhängige Ableitelemente, welche sich für den vorgenannten Zweck eignen, sind beispielsweise Metalloxidvaristoren, deren Widerstandswerte hohe negative Spannungskoeffizienten aufweisen. Metalloxidvaristoren für die Ableitung von Überspannungen sind hoch belastbar und haben unter normaler Betriebsspannung einen sehr geringen, meist weniger als 1 mA betragenden Ableitwechselstrom. Deshalb ist es grundsätzlich nicht nötig, solche Ableitelemente nach einem infolge Überspannung auftretenden Ableitstossstrom vom Stromversorgungsnetz abzutrennen, weil bei diesem im Gegensatz zu anderen bekannten Überspannungsableitern hierbei kein Folgestrom auftritt, welcher den Widerstandskörper übermässig erwärmen oder gar zerstören könnte. Vielmehr sinkt der Ableitstrom nach einem Stromstoss innerhalb kürzester Zeit bis auf den geringen Ableitwechselstrom ab.

Unter Ableitwechselstrom wird hier der bei normalem Netzbetrieb durch die Ableitelemente zum Erdpotential fliessende Strom verstanden, der sich aus einer ohm'schen Komponente (Leckstrom) und einer kapazitiven Komponente zusammensetzt. Als Normalbetrieb gilt dabei ein Betriebszustand, bei dem die Netzspannung den Sollwert einnimmt bzw. nach einem vorübergehenden Übermass, z.B. nach einem Blitzschlag, den Sollwert wenigstens annähernd wieder erreicht hat.

Anders liegt der Fall, wenn ein Ableitelement dieser Art durch einen übermässig hohen Ableitstossstrom überlastet wird und dadurch seine charakteristischen Eigenschaften verliert. Der Widerstandswert des Ableitelementes kann unter solchen ausserordentlichen Betriebsumständen derart stark abnehmen, dass der Ableitwechselstrom den Normalwert um ein Mehrfaches übersteigt. Diese Stromerhöhung kann den Widerstandskörper des Ableitelementes erwärmen und zerstören, oder gar einen Brand verursachen.

Ähnliche Gefahrensituationen können auch bei Überspannungsableitern mit Kombinationen von Ableitelementen und Funkenstrecken auftreten, wenn der Lichtbogen über der Funkenstrecke stehen bleibt, d.h. nicht im erwarteten Zeitpunkt erlischt.

Bei der Lösung dieses Problems geht es aber nicht nur darum, ein gefährdetes oder bereits zerstörtes Ableitelement vom Netz abzuschalten, um weiteren materiellen Schaden an der Schutzanordnung und deren Umgebung zu vermeiden. Vielmehr ist dabei in Betracht zu ziehen, dass die zu schützenden elektrischen Einrichtungen durch einen überhöhten Ableitwechselstrom in nicht oder nicht rechtzeitig abgeschalteten Ableitelementen ein für Personen gefährliches Spannungspotential gegenüber dem Erdpotential annehmen können, insbesondere wenn solche Einrichtungen mangelhaft geerdet sind. Unter diesem Gesichtspunkt gilt es also zu verhindern, dass der Ableitwechselstrom auf übermässige Werte ansteigen kann.

Es sind verschiedene Schutzanordnungen ähnlicher Art bekannt geworden, welche mit Einrichtungen zur Abschaltung eines überhöhten Ableitwechselstromes zusammenarbeiten.

Die DE-OS 41 27 457 offenbart eine Überspannungs-Schutzeinrichtung, die mit einem Ableitertrennschalter ausgerüstet ist. Dieser ist als handelsüblicher Fehlerstromschutzschalter ausgebildet, in den die Überspannungsableiter eingebaut sind. Die von den Überspannungsableitern zur Erde führenden Strompfade sind parallelgeschaltet und durch den Kern eines Stromwandlers hindurchgeführt, an dessen Sekundärwicklung ein Relais zur Auslösung des Ableitertrennschalters angeschlossen ist. Dieses Relais wird durch den bei einer Überspannung auf dem Netz auftretenden Ableitstromstoss betätigt, so dass die Schutzeinrichtung vom Netz abgetrennt wird. Damit entfällt deren Schutzwirkung im Falle weiterer Überspannungen auf dem Netz. Der Ableitertrennschalter dient eigentlich dazu, die Schutzeinrichtung vom Netz abzutrennen, wenn schadhaft gewordene Überspannungsableiter im Normalbetrieb einen zu hohen Ableitwechselstrom führen und sich dadurch übermässig erwärmen könnten. Ein überhöhter Ableitwechselstrom wird durch dessen Wärmewirkung im Überspannungsableiter mit Hilfe eines Temperatursensors erfasst, welcher in einem separaten Stromkreis über eine zusätzliche Primärwicklung des Stromwandlers das Relais steuert. Infolge der Abtrennung der Schutzeinrichtung im Falle einer Überspannung einerseits und eine im Schadenfall durch die thermische Auslösung verzögerte Abtrennung derselben andererseits wird die Schutzwirkung hinsichtlich der netzbetriebenen Einrichtungen und der damit hantierenden Personen erheblich beeinträchtigt, da eine Abschaltung dieser Einrichtungen vom Netz nicht vorgesehen ist.

In der FR-PS 14 60 049 ist eine Schutzeinrichtung beschrieben, welche ein isoliertes Niederspannungs-Drehstromnetz bei zu hohen Spannungen oder Asymmetrien hochspannungsseitig abschaltet. Dabei stellt im Falle eines fehlerhaften Verbrauchers ein gezündeter Gasableiter die Verbindung zur Erde sicher, während ein Vorwiderstand, nach dem Schmelzen einer diesen überbrückenden Sicherung, den Kurzschlussstrom begrenzt. Die Hochspannungsseite wird durch einen Schalter abgeschaltet, welcher thermisch oder elektromagnetisch über den Kurzschlussstrom angesteuert wird. Der Gasableiter ist hier das eigentliche Schaltelement, welches die Hochspannungsabschaltung einleitet. Erfahrungsgemäss ist eine Schutzeinrichtung dieser Art nicht geeignet, Geräte bzw. Personen bei gleichzeitiger Eigenüberwachung zu schützen.

Die AT-PS 391 571 zeigt eine Schutzeinrichtung, die im Fehlerfall über einen Stromwandler die Ableitelemente von der Schutzerde trennt. Durch eine derartige Abschaltung wird die eigentliche Funktion des Überspannungsschutzes aufgehoben. Auf eine thermische Überwachung der Ableitelemente kann trotzdem nicht verzichtet werden, da die in der genannten Weise abgetrennten Ableitelemente weiterhin zwischen Phasenleiter und Nulleiter eingeschaltet bleiben. Ferner wurde bei der gezeigten Schutzanordnung der im Störungsfall auftretende induktive Spannungsabfall auf dem Schutzleiter und der damit verbundene Anstieg des Massepotentials der Schutzeinrichtung auf möglicherweise gefährliche Werte nicht berücksichtigt. Infolgedessen kann die beschriebene Schutzeinrichtung nur als Grobschutz einer Netzinstallation in einem Gebäude, nicht aber zum Schutz von Personen und Geräten dienen.

Eine andere bekannte Schutzanordnung weist eine Abtrennvorrichtung in Form einer Schmelzlotsicherung auf. Diese steht in wärmeleitendem Kontakt mit dem Ableitelement und schmilzt, wenn das Ableitelement die Schmelztemperatur erreicht. Beim Schmelzen der Schmelzlotsicherung wird eine gespannte Feder freigegeben, welche einen elektrischen Kontakt zum Abtrennen des Ableitelementes betätigt.

Nachteilig bei dieser Schutzanordnung ist die Trägheit der Abtrennvorrichtung, indem ein verhältnismässig grosser Strom während einer bestimmten Zeit durch den Ableitelement fliessen muss, um diesen auf die Schmelztemperatur der Schmelzlotsicherung zu bringen. Während dieser Zeit sind Personen und weiterbetriebene elektrische Einrichtungen nicht genügend geschützt.

Bei einer anderen bekannten Schutzanordnung ist dem Überspannungsableiter ein Fehlerstrom-Schutzschalter vorgeschaltet, welcher mit Hilfe von Stromwandlern den Phasenstrom bzw. die Summe der Phasenströme mit dem Strom im Nulleiter vergleicht. Im Falle eines gegen Erde abfliessenden Folgestromes schaltet der Fehlerstrom-Schutzschalter die zu schützende elektrische Einrichtung vom Netz ab.

Ein wesentlicher Nachteil dieser Schutzanordnung besteht darin, dass der Fehlerstrom-Schutzschalter auf der ungeschützten Seite der Netzverbindung eingesetzt werden muss und daher vom gesamten Ableitstossstrom aus der abzuleitenden Überspannung durchflossen wird. Der Fehlerstrom-Schutzschalter, welcher in der Regel nicht für eine derart hohe Beanspruchung bemessen ist, wird dabei meist zerstört. Mit Ableiterelementen am Fehlerstrom-Schutzschalter lassen sich die erwähnten Verhältnisse kaum verbessern.

Immerhin lässt der zuletzt genannte Lösungsvorschlag erkennen, dass es für den Schutz von Personen und Einrichtungen unter den gegebenen Umständen sicherer ist, im Falle eines überhöhten Ableitwechselstromes nicht nur das betroffene Ableitelement, sondern auch die zu schützende Einrichtung vom Stromversorgungsnetz abzutrennen.

Die Erfindung stellt sich aufgrund dieser Erkenntnis die Aufgabe, eine Schutzanordnung der eingangs genannten Art zu schaffen, welche unter Vermeidung der Nachteile bisheriger Schutzanordnungen bei einem unzulässig hohen Ableitwechselstrom in einem oder mehreren der Ableitelemente eine sichere Netzabschaltung bewirkt, und zwar bevor ein überhöhter Ableitwechselstrom und eine unzulassig hohe Erwärmung der betroffenen Ableitelemente auftritt. Andererseits soll eine Netzabschaltung aufgrund eines Ableitstromstosses infolge Überspannung vermieden werden, wenn danach der Ableitwechselstrom wider seinen normalen Wert annimmt. Dadurch kann ein zuverlässiger Schutz von Personen und Einrichtungen gewährleistet werden.

Der Grundgedanke der Erfindung besteht darin, als Kriterium für die Netzabschaltung die Grösse und den zeitlichen Verlauf des Ableitstossstromes bzw. den Ableitwechselstrom direkt zu überwachen. Dementsprechend ist die erfindungsgemässe Schutzanordnung dadurch gekennzeichnet, ein elektronisches Auswertegerät (16) zum Steuern einer der Schutzanordnung vorgeschalteten Netzschalteinrichtung (2) vorgesehen ist, welches den die Ableitelemente (5 bis 8; 38, 39) gesamthaft durchfliessenden Ableitwechselstromes (I_{A}) erfasst und ein von der Messgrösse (I_{A}) abhängiges Signal zur Abschaltung der zu schützenden Einrichtung (1) vom Stromversorgungsnetz liefert, wenn der im Normalbetrieb durch die Ableitelemente (5 bis 8; 38, 39) fliessende Ableitwechselstrom einen einstellbaren Grenzwert überschreitet, und dass das Auswertegerät (16) ein Zeitglied mit einstellbarer Verzögerungszeit enthält, welches die Auslösung des Abschaltsignals solange verzögert, bis die eingestellte Verzögerungszeit abgelaufen ist.

Als Grenzwert des Ableitwechselstromes ist ein Mass vorzusehen, welches über dem Normalwert des Ableitwechselstromes liegt, aber unterhalb von Werten, welche bei mangelhafter Schutzerde für Personen gefährlich werden können. Da der Ableitwechselstrom herkömmlicher Metalloxidvaristoren normalerweise weniger als 1 mA beträgt, kann der Grenzwert für den Ableitwechselstrom auf einen sehr tiefen, für Personen im allgemeinen ungefährlichen Wert von z.B. 10 mA festgelegt werden.

Normalerweise sind die Ableitelemente über eine gemeinsame Verbindungsleitung mit dem Erdpotential verbunden. Diese Verbindungsleitung, welche den gesamten Ableitstossstrom führt und in welche der Messwandler einzuschalten ist, sollte jedoch möglichst kurz sein, um den ohmschen und insbesondere den induktiven Spannungsabfall zwischen den Ableitelementen und dem Erdpotential möglichst klein zu halten, weil sonst bei sehr hohen Ableitstossströmen mit grosser Steilheit (Blitzschlag, nuklearer elektromagnetischer Puls) das Massepotential der Schutzanordnung auf Werte ansteigen kann, welche für Personen und Einrichtungen gefährlich sind. Auf jeden Fall ist eine Anordnung des Messwandlers an einem von der Schutzanordnung entfernten Standort zu vermeiden, was zwangsläufig eine längere Verbindungsleitung zum Erdpotential erfordern würde.

In Anbetracht dessen besteht eine vorteilhafte praktische Ausführungsform der Erfindung darin, dass die Ableitelemente erdseitig an eine Sammelschiene angeschlossen sind und dass der Messwandler zwischen die Sammelschiene und einen Massepol der Schutzanordnung eingeschaltet ist.

Vorzugsweise ist der Messwandler ein Stabstromwandler, dessen Primärleiter in Form eines nicht magnetisierbaren Leiterstücks zwischen zwei elektrisch leitenden Platten angeordnet und mit diesen fest verbunden ist, wobei die eine Platte den Massepol der Schutzanordnung bildet, während auf der anderen, die Sammelschiene bildenden Platte die Ableitelemente aufgebaut sind. Mit Vorteil ist dabei die den Massepol der Schutzanordnung bildende Platte als Teil eines durchgehenden Erdpotentialleiters ausgebildet. Eine Konstruktion dieser Art ermöglicht eine Ableitverbindung von minimaler Länge mit einer entsprechend geringen Eigeninduktivität. Diese einfache Lösung ermöglicht es auch, auf einen Trenntransformator zu verzichten, wie er in bekannten Schutzanordnungen eingesetzt wird, um induktive Spannungsabfälle zu eliminieren. Solche Trenntransformatoren sind gegen sehr hohe Spitzenspannungen zu isolieren und sind daher in der Regel entsprechend schwer und teuer, was sich insbesondere bei der Verwendung in mobilen Geräten und Anlagen nachteilig auswirkt.

Eine besonders vorteilhafte Lösung lässt sich im weiteren dadurch erzielen, dass das als Primärleiter des Messwandlers dienende Leiterstück hohl ausgebildet ist und dass die geschützten Leitungen den Messwandler im Hohlraum dieses Leiterstücks durchsetzen. Auf diese Weise wird der am Leiterstück auftretende induktive Spannungsabfall mit umgekehrtem Vorzeichen in den Ausgangskreis übertragen und dadurch der ursprüngliche Spannungsabfall kompensiert. Zudem werden durch diese Massnahme jeder Phasenleiter und der Nulleiter auf mögliche Fehlerströme von nachgeschalteten Verbrauchern mitüberwacht.

Das Auswertegerät enthält ein Zeitglied, welches die Auslösung des Abschaltsignals solange verzögert, bis ein bei einer transienter Überspannung (Blitzschlag, NEMP) auftretender, über die Ableitelemente abgeleiteter Ableitstossstrom unter den eingestellten Grenzwert abgeklungen ist. Auf diese Weise wird eine Netzabschaltung vermieden, wenn nach dem Wirksamwerden der Spannungsbegrenzung aufgrund einer Überspannung auf dem Stromversorgungsnetz, z.B. infolge eines Blitzschlags, der Ableitwechselstrom innerhalb der eingestellten Zeitverzögerung wieder auf den normalen Stromwert abgesunken ist. In Fällen dieser Art wird daher der Betrieb der zu schützenden Einrichtung nicht unterbrochen, trotz den dabei auftretenden hohen Ableitstossströmen.

Erfahrungsgemäss beträgt die Dauer eines infolge Blitzschlags durch die betroffenen Ableitelemente fliessenden Ableitstossstroms wenige Millisekunden, so dass der Ableitstossstrom nach Ablauf einer z.B. auf 10 ms eingestellten Verzögerungszeit bereits wieder auf den Normalwert des Ableitwechselstromes abgeklungen ist und somit die Auslösung eines Abschaltsignals unterbleibt. Einzig bei einem Defekt eines Ableitelementes, welcher sich durch einen anhaltend überhöhten Ableitwechselstrom bemerkbar macht, erfolgt nach Ablauf der Verzögerungszeit die Auslösung des Signals zur Abschaltung der zu schützenden Einrichtung vom Stromversorgungsnetz.

Anhand der beigefügten Zeichnung werden nachstehend Ausführungsbeispiele der Erfindung näher erläutert. In der Zeichnung bedeuten:
- Fig. 1: Schema einer elektrischen Anlage mit einer ersten Ausführungsform der erfindungsgemässen Schutzanordnung;
- Fig. 2: Schema der gleichen elektrischen Anlage mit einer zweiten Ausführungsform der erfindungsgemässen Schutzanordnung; und
- Fig. 3: eine als Durchführung konzipierte Schutzanordnung in schematischer Darstellung.

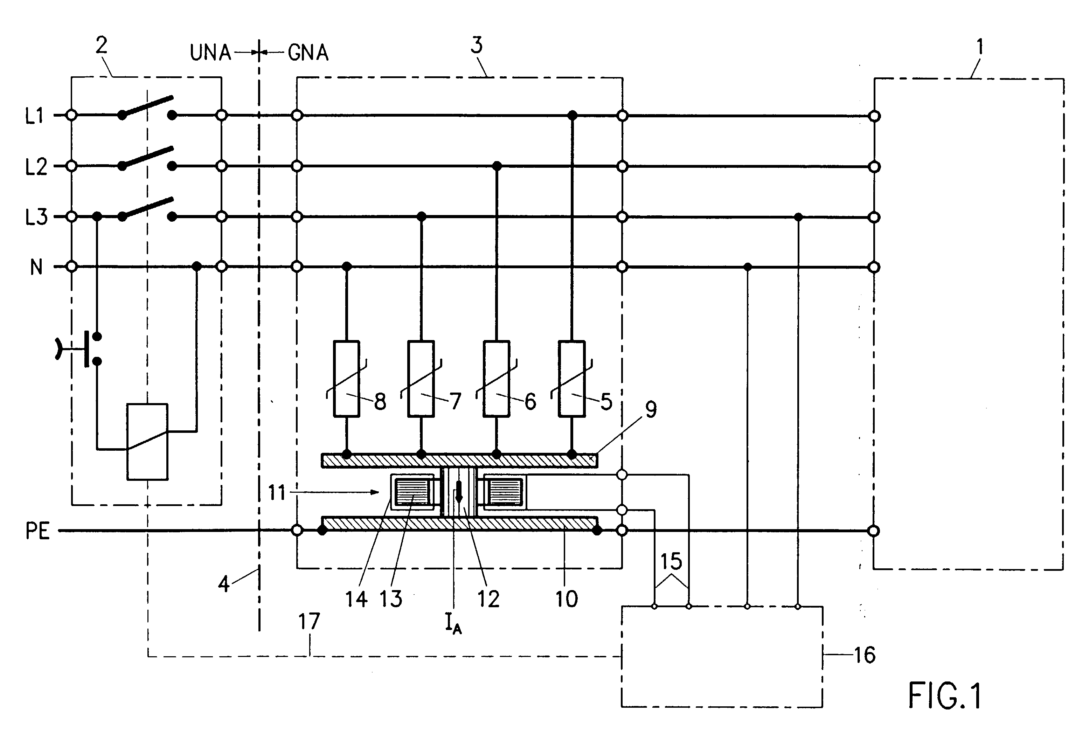

In Fig. 1 der Zeichnung ist eine elektrische Anlage schematisch dargestellt, in welcher für die Stromversorgung einer gegen Überspannung zu schützenden Einrichtung 1 ein Dreiphasen-Wechselstromnetz dient, welches die drei Phasenleiter L1, L2, L3 und den Nulleiter N umfasst. Ferner ist ein Erdpotentialleiter PE vorgesehen. Zum Ein- und Ausschalten der Stromzufuhr zur Einrichtung 1 ist eine ferngesteuerte Schalteinrichtung 2 vorhanden. Die erfindungsgemässe Schutzanordnung ist mit 3 bezeichnet. Die Trennlinie 4 deutet an, welche Anlageteile sich auf dem ungeschützten Netzabschnitt UNA befinden und welche auf dem geschützten Netzabschnitt GNA.

Die Schutzanordnung 3 enthält vier spannungsabhängige Ableitelemente 5 bis 8, vorzugsweise Metalloxidvaristoren, welche einerseits je an einen der Phasenleiter L1, L2, L3 und den Nulleiter N angeschlossen und andererseits mit einer gemeinsamen, eine Sammelschiene bildenden Platte 9 verbunden sind. Die Platte 9 kann zugleich als mechanischer Träger der Ableitelemente 5 bis 8 dienen. Parallel zu der Platte 9 ist mit geringem Abstand von z.B. 20 mm eine Masseplatte 10 angeordnet, welche als Teil des durchgehenden Erdpotentialleiters PE ausgebildet ist. Sowohl die Platte 9 als auch die Masseplatte 10 bestehen aus elektrisch leitendem Material.

Zur Erfassung des die Ableitelemente 5 bis 8 gesamthaft durchfliessenden Ableitwechselstromes I_{A} ist zwischen den beiden Platten 9 und 10 ein Messwandler 11 angeordnet. Dieser ist ein Stabstromwandler mit einem Primärleiter in Form eines nicht magnetisierbaren Leiterstücks, im vorliegenden Beispiel eines Zapfens 12, welcher mit den Platten 9 und 10 fest verbunden ist. Der Zapfen 12 führt den gesamten aus den Ableitelementen 5 bis 8 abfliessenden Ableitwechselstrom I_{A} und hat einen genügend grossen Querschnitt, z.B. einen Durchmesser von 10 bis 15 mm, um einen kurzzeitigen Ableitstossstrom von z.B. 100 kA schadlos zu übertragen. Den Zapfen 12 umgibt ein ringförmiger Magnetkern 13, welcher eine Ringwicklung 14 trägt, an der ein dem zu überwachenden Ableitwechselstrom I_{A} proportionaler Sekundärstrom I_{S} als Messgrösse anfällt.

Die Messgrösse I_{S} wird über die Leitungen 15 einem Auswertegerät 16 zugeführt. Dieses enthält eine elektronische Auswerteschaltung, an der die Ansprechschwelle des Ableitwechselstromes und die Verzögerungszeit einstellbar sind. Schaltungsanordnungen dieser Art sind an sich bekannt und werden hier nicht näher beschrieben.

Das Auswertegerät 16 erzeugt ein Signal, wenn der überwachte Ableitwechselstrom nach Ablauf der eingestellten Verzögerungszeit einen über dem eingestellten Grenzwert liegenden Wert aufweist. Dieses Signal löst über eine Wirkverbindung 17 die Schalteinrichtung 2 aus und bewirkt auf diese Weise die Abschaltung der zu schützenden Einrichtung 1 vom Stromversorgungsnetz. Die Signalübertragung über die Wirkverbindung 17 kann elektrisch, mechanisch, hydraulisch, pneumatisch oder mittels einer Fiberoptik erfolgen. Zudem kann von dem Auswertegerät 16 ein Signal ausgehen, welches an geeigneter Stelle anzeigt, dass in der Schutzanordnung ein Defekt vorliegt.

Eine weitere Anwendung der erfindungsgemässen Schutzeinrichtung ist der Schutz von mobilen Einrichtungen, z.B. Fahrzeugen, gegen Blitz- und NEMP-Einwirkungen. Die dafür benötigte Schutzerdung fehlt oft, so dass aus Gründen des Personenschutzes häufig eine doppelte Isolation mit einer Isolationsspannung von beispielsweise 4 KV_{AC} gefordert wird. Fliesst ein zu hoher Ableitwechselstrom durch schadhafte Ableitelemente von einem Phasenleiter zur Fahrzeugmasse oder zu einer nach Art eines Faradaykäfigs geschirmten Kabine, auf die sich die eingesetzten Ableitelemente beziehen, so kann die Fahrzeugmasse unter Netzspannung zu stehen kommen. Durch die Verwendung der erfindungsgemässen Schutzanordnung kann auch in diesem Fall bei einer geringen Zunahme der Ableitwechselströme in den Ableitelementen die Netzspannung in der Stromversorgungsleitung abgeschaltet werden. Dadurch sind Personen und Einrichtungen sicher geschützt.

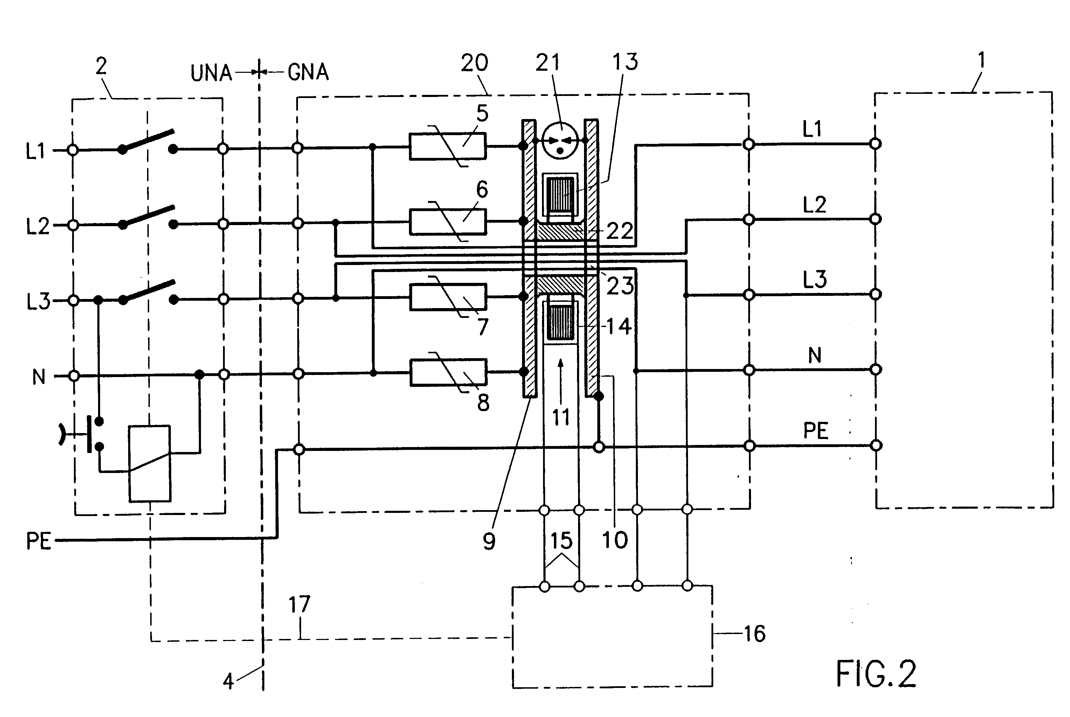

Bei der Ausführungsform nach Fig. 2 weist die Schutzanordnung 20 zusätzlich einen gasgefüllten Ableiter 21 auf, welcher zwischen die beiden Platten 9 und 10 geschaltet ist und den an diesen Platten auftretenden Spannungsabfall begrenzt. Mit dieser Massnahme wird dem Umstand Rechnung getragen, dass durch die Verwendung des ringförmigen Magnetkerns 13' die Eigeninduktivität des Zapfens 12 und damit auch der an diesem auftretende induktive Spannungsabfall erhöht wird. Da dieser Ableiter 21 nur während eines Stromanstiegs leitend ist, wird er nur wenig belastet.

Ein weiterer Unterschied zur Ausführungsform nach Fig. 1 besteht darin, dass der als Primärleiter des Messwandlers 11 dienende Zapfen 22 eine achsiale Durchgangsbohrung 23 aufweist und dass die geschützten Leitungen, d.h. die Phasenleiter L1, L2 und L3 und der Nulleiter N, ebenfalls durch den Messwandler 11 geführt sind, indem sie diesen in der genannten Durchgangsbohrung 23 durchsetzen. Auf diese Weise wird der am Zapfen 22 auftretende induktive Spannungsabfall mit umgekehrtem Vorzeichen in den Ausgangskreis übertragen und dadurch der ursprüngliche Spannungsabfall kompensiert. Zudem werden die Ableitelemente 5 bis 8 und gleichzeitig die Phasenleiter L1, L2, L3 und der Nulleiter N auf mögliche Fehlerströme von nachgeschalteten Verbrauchern überwacht. Im fehlerfreien Betrieb ist die Summe der Phasenströme gleich dem Strom im Rückleiter. Im Messwandler 11 kompensieren sich diese Ströme, so dass dessen Magnetkern 13 nicht magnetisiert wird. Tritt dagegen ein Fehler auf, so fliesst über den Zapfen 22 ein Strom gegen Erde, welcher im Messwandler 11 eine Spannung erzeugt, was, wie im Falle eines überhöhten Ableitwechselstromes in den Ableitelementen 5 bis 8, zu einer Netzabschaltung führt, sobald der eingestellte Strom- und Zeitwert überschritten wird.

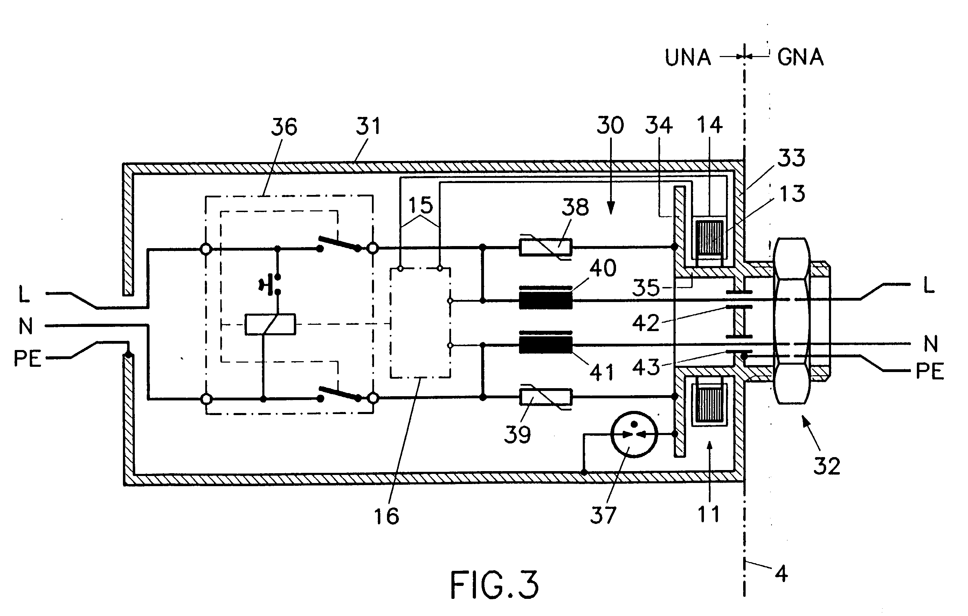

Die Fig. 3 zeigt schematisch eine als Durchführung konzipierte Schutzanordnung 30 für ein Zweileiternetz (L, N) mit zusätzlichem Erdpotentialleiter PE. Die Schutzanordnung 30 ist in ein Gehäuse 31 mit Montageverschraubung 32 eingebaut. Dabei ist es gleichgültig, ob sich die Montageverschraubung 32 im geschützten Netzabschnitt GNA gemäss Fig. 3 oder im ungeschützten Netzabschnitt UNA befindet. Das Gehäuse 31 bildet als Teil des durchgehenden Erdpotentialleiters PE den Massepol der Schutzanordnung 30. Nahe des an die Montageverschraubung 32 angrenzenden Bodens 33 des Gehäuses 31 ist eine ringförmige Sammelschiene 34 und zwischen dem Boden 33 und der Sammelschiene 34 der Messwandler 11 angeordnet. Den Primärleiter des Messwandlers 11 bildet hier ein kurzes Rohrstück 35, das die Sammelschiene 34 mit dem Boden 33 des Gehäuses 31 verbindet. Die Leiter L und N sind in diesem Rohrstück 35 durch den Messwandler 11 geführt.

Die Schalteinrichtung 36 für die Abschaltung eines an die Schutzeinrichtung 30 angeschlossenen Verbrauchers vom Stromversorgungsnetz sowie das Auswertegerät 16 befinden sich ebenfalls innerhalb des Gehäuses 31 der Schutzanordnung 30. Ein gasgefüllter Ableiter 37, der die gleiche Funktion hat wie der Ableiter 21 in Fig. 2, ist zwischen die Sammelschiene 34 und das Gehäuse 31 eingeschaltet.

An jeden Leiter L bzw. N und die Sammelschiene 34 ist ein Ableitelement 38 bzw. 39 angeschlossen. Als Ausführungsvariante ist hier jedem Ableitelement 38 bzw. 39 ein Tiefpassfilter nachgeschaltet, das je aus einer Drossel 40 bzw. 41 und einem Durchführungskondensator 42 bzw. 43 besteht.

Bei dieser praktischen Lösung werden die Ableitelemente 38, 39 und zugleich die Tiefpassfilter 40, 42 und 41, 43 auf ihre Funktion überwacht und gleichzeitig im geschützten Netzabschnitt GNA Fehlerströme detektiert und gegebenenfalls abgeschaltet.

## Patentansprüche

1. Schutzanordnung zum Schutz von mit Wechselstrom betriebenen elektrischen Einrichtungen (1) gegen Überspannungen auf dem Stromversorgungsnetz, mit spannungsabhängigen Ableitelementen (5-8) zur Spannungsbegrenzung, wobei an jede Leitung (L₁,L₂,L₃,N) des Stromversorgungsnetzes ein Ableitelement angeschlossen ist und die von den Ableitelementen zur Erde führenden Strompfade parallelgeschaltet und durch den Kern eines Stromwandlers (11) hindurchgeführt sind, dessen Sekundärwicklung (13) mit einem Auswertegerät verbunden ist, dadurch gekennzeichnet, dass ein elektronisches Auswertegerät (16) zum Steuern einer der Schutzanordnung vorgeschalteten Netzschalteinrichtung (2) vorgesehen ist, welches den die Ableitelemente (5 bis 8; 38, 39) gesamthaft durchfliessenden Ableitwechselstromes (I_{A}) erfasst und ein von der Messgrösse (I_{A}) abhängiges Signal zur Abschaltung der zu schützenden Einrichtung (1) vom Stromversorgungsnetz liefert, wenn der im Normalbetrieb durch die Ableitelemente (5 bis 8; 38, 39) fliessende Ableitwechselstrom einen einstellbaren Grenzwert überschreitet, und dass das Auswertegerät (16) ein Zeitglied mit einstellbarer Verzögerungszeit enthält, welches die Auslösung des Abschaltsignals solange verzögert, bis die eingestellte Verzögerungszeit abgelaufen ist.

2. Schutzanordnung nach Anspruch 1, dadurch gekennzeichnet, dass die Ableitelemente (5 bis 8; 38, 39) erdseitig an eine Sammelschiene (9; 34) angeschlossen sind und dass der Messwandler (11) zwischen die Sammelschiene (9; 34) und einen Massepol (10; 33) der Schutzanordnung (3; 20; 30) eingeschaltet ist.

3. Schutzanordnung nach Anspruch 2, dadurch gekennzeichnet, dass zwischen die Sammelschiene (9; 34) und den Massepol (10; 33) ein gasgefüllter Ableiter (21; 27) als Spannungsbegrenzer eingeschaltet ist.

4. Schutzanordnung nach Anspruch 2, dadurch gekennzeichnet, dass der Messwandler (11) ein Stabstromwandler ist, dessen Primärleiter in Form eines nicht magnetisierbaren Leiterstücks (12; 22; 35) zwischen zwei elektrisch leitenden Platten (9, 10; 33, 34) angeordnet und mit diesen fest verbunden ist, wobei die eine Platte (10; 33) den Massepol der Schutzanordnung bildet, während auf der anderen, die Sammelschiene bildenden Platte (9; 34) die Ableitelemente (5 bis 8; 38, 39) aufgebaut sind.

5. Schutzanordnung nach Anspruch 4, dadurch gekennzeichnet, dass die den Massepol der Schutzeinrichtung bildende Platte (10; 33) als Teil eines durchgehenden Erdpotentialleiters (PE) ausgebildet ist.

6. Schutzanordnung nach Anspruch 4, dadurch gekennzeichnet, dass das als Primärleiter des Messwandlers dienende Leiterstück (22; 35) hohl ausgebildet ist und dass die geschützen Leitungen (L1, L2, L3, N) den Messwandler (11) im Hohlraum (23) dieses Leiterstücks (22; 35) durchsetzen.

## Claims

1. Protection device for protecting electrical appliances (1) operating with alternating current, against overvoltage in the power distribution network, with voltage-dependent shunt elements (5-8) for limiting the voltage, a shunt element being connected to each line (L1, L2, L3, N) of the power distribution network and the current paths leading from the shunt elements to earth being connected in parallel and guided through the core of a current transformer (11), whereof the secondary winding (13) is connected to an evaluation device, characterised in that an electronic evaluation device (16) is provided for controlling a mains switching device (2) connected on the supply side of the protection device, which mains switching device (2) ascertains the shunt alternating current (I_{A}) flowing in total through the shunt elements (5 to 8; 38, 39) and supplies a signal dependent on the measured quantity (I_{A}) for disconnecting the appliance (1) to be protected from the power distribution network, when the shunt alternating current flowing through the shunt elements (5 to 8; 38, 39) during normal operation exceeds an adjustable limit value, and that the evaluation device (16) contains a timing element with an adjustable delay time, which delays the release of the switching-off signal until the adjusted delay time has expired.

2. Protection device according to Claim 1, characterised in that the shunt elements (5 to 8; 38, 39) are connected on the earth side to a bus bar (9; 34) and that the measuring transformer (11) is connected between the bus bar (9; 34) and an earth pole (10; 33) of the protection device (3; 20; 30).

3. Protection device according to Claim 2, characterised in that a gas-filled surge diverter (21; 27) is connected as a voltage limiter between the bus bar (9; 34) and the earth pole (10; 33).

4. Protection device according to Claim 2, characterised in that the measuring transformer (11) is a bar-type current transformer, whereof the primary conductor in the form of a non-magnetizable conductor element (12; 22; 35) is located between two electrically conducting plates (9, 10; 33, 34) and is securely connected thereto, one plate (10; 33) forming the earth pole of the protection device, whereas the shunt elements (5 to 8; 38, 39) are installed on the other plate (9; 34) forming the bus bar.

5. Protection device according to Claim 4, characterised in that the plate (10; 33) forming the earth pole of the protection device is constructed as part of a continuous earth potential conductor (PE).

6. Protection device according to Claim 4, characterised in that the conductor element (22; 35) serving as the primary conductor of the measuring transformer is constructed to be hollow and that the protected lines (L1, L2, L3, N) pass through the measuring transformer (11) in the cavity (23) of this conductor element (22; 35).

## Revendications

1. Agencement de protection permettant de protéger des installations électriques (1), alimentées en courant alternatif, vis-à-vis de surtensions apparaissant sur le réseau d'alimentation en courant, cet agencement comprenant des éléments de décharge (5-8) dépendant de la tension et servant à une limitation de tension, un élément de décharge respectif étant raccordé à chaque ligne (L1, L2, L3, N) du réseau d'alimentation en courant, tandis que les trajets de courant menant des éléments de décharge à la terre sont connectés en parallèle et traversent le noyau d'un transformateur de courant (11) dont l'enroulement secondaire (13) est relié à un appareil d'exploitation, caractérisé en ce qu'il est prévu un appareil électronique d'exploitation (16) qui sert à commander un dispositif de connexion de réseau (2) disposé en amont de l'agencement de protection et qui relève le courant alternatif de décharge (I_{A}) passant dans les éléments de décharge (5 à 8 ; 38, 39) dans leur ensemble et fournit un signal dépendant de la valeur mesurée (I_{A}) et servant à déconnecter du réseau d'alimentation en courant l'installation à protéger (1), lorsque le courant alternatif de décharge passant en fonctionnement normal par les éléments de décharge (5 à 8 ; 38, 39) franchit vers le haut une valeur limite réglable et en ce que l'appareil d'exploitation (16) contient un organe de temporisation à durée de temporisation réglable qui retarde le déclenchement du signal de déconnexion aussi longtemps que la durée de temporisation réglée ne s'est pas écoulée.

2. Agencement de protection selon la revendication 1, caractérisé en ce que en ce que les éléments de décharge (5 à 8 ; 38, 39) sont connectés, du côté de la terre, à une barre collectrice (9 ; 34) et en ce que le transducteur (11) est connecté entre la barre collectrice (9 ; 34) et un pôle de masse (10 ; 33) de l'agencement de protection (3 ; 20 ; 30).

3. Agencement de protection selon la revendication 2, caractérisé en ce qu'un éclateur (21 ; 27) à remplissage de gaz est connecté, en tant que limiteur de tension, entre la barre collectrice (9 ; 34) et le pôle de masse (10 ; 33).

4. Agencement de protection selon la revendication 2, caractérisé en ce que le transducteur (11) est un transformateur de courant à barre dont le conducteur primaire est disposé, sous forme d'un tronçon de ligne non magnétisable (12 ; 22 ; 35), entre deux plaques électriquement conductrices (9, 10 ; 33, 34) et est relié rigidement à ces plaques, une première plaque (10 ; 33) constituant le pôle de masse de l'agencement de protection, tandis que les éléments de décharge (5 à 8 ; 38, 39) sont montés sur l'autre plaque (9 ; 34) qui constitue la barre collectrice.

5. Agencement de protection selon la revendication 4, caractérisé en ce que la plaquette (10 ; 33) constituant le pôle de masse du dispositif de protection est réalisée sous forme d'une partie d'une ligne continue de potentiel de terre (PE).

6. Agencement de protection selon la revendication 4, caractérisé en ce que le tronçon de ligne (22 ; 35) servant de conducteur primaire du transducteur est réalisé creux et en ce que les lignes protégées (L1, L2, L3, N) traversent le transducteur (11) dans la cavité (23) de ce tronçon de ligne (22 35).
